Europäisches Patentamt

European Patent Office

Office européen des brevets

(19)

(11) Veröffentlichungsnummer : **0 047 900**
**B1**

(12) # EUROPÄISCHE PATENTSCHRIFT

(45) Veröffentlichungstag der Patentschrift :
28.11.84

(21) Anmeldenummer : 81106740.4

(22) Anmeldetag : 28.08.81

(51) Int. Cl.³ : **H 02 P   7/44, G 01 R 27/02**

(54) **Verfahren und Vorrichtung zum Ermitteln des Läuferwiderstandes einer Asynchronmaschine.**

(30) Priorität : 11.09.80 DE 3034251

(43) Veröffentlichungstag der Anmeldung :
24.03.82 Patentblatt 82/12

(45) Bekanntmachung des Hinweises auf die Patenterteilung : 28.11.84 Patentblatt 84/48

(84) Benannte Vertragsstaaten :
**AT CH DE FR GB IT LI NL SE**

(56) Entgegenhaltungen :
**CH-A-   578 801**
**DE-B- 1 917 567**
**DE-B- 1 941 312**
**DE-B- 2 833 542**
**GB-A- 1 312 618**
**REGELUNGSTECHNIK UND PROZESSDATENVER-
ARBEITUNG, vol. 21, Heft 4, 1973, München, F.
BLASCHE UND D. STRÖLE "Transformationen zur
Entflechtung elektrischer Antriebsregelstrecken",
Selten 105-109**

(73) Patentinhaber : **Siemens Aktiengesellschaft
Berlin und München Wittelsbacherplatz 2
D-8000 München 2 (DE)**

(72) Erfinder : **Bayer, Karl-Heinz, Dipl.-Ing.
Friedrich-Bauer-Strasse 3
D-8520 Erlangen (DE)**
Erfinder : **Blaschke, Felix, Dr. Dipl.-Ing.
Steinforststrasse 19
D-8520 Erlangen (DE)**

## Beschreibung

Die Erfindung betrifft ein Verfahren zum Ermitteln des Läuferwiderstandes einer Asynchronmaschine sowie eine Vorrichtung zur Durchführung des Verfahrens.

Moderne, hochdynamische Vierquadratantriebe mit Asynchronmaschinen arbeiten häufig mit feldorientierter Regelung, d. h. die Sollwerte für die Phasenströme in den Ständerwicklungen, die zu einem Ständerstromvektor i zusammengesetzt werden können, werden so vorgegeben, daß der Vektor des Soll-Ständerstromes einen vorgegebenen Winkel mit der Achse des magnetischen Feldes der Drehfeldmaschine umschreibt. Benutzt man zur Beschreibung des magnetischen Feldes den magnetischen Flußvektor $\Psi$, so ermöglicht die feldorientierte Regelung bei Kenntnis der Winkellage des Flußvektors, die zum Flußvektor parallele Komponente $i_{\varphi1}$ des Ständerstromes (Magnetisierungsstrom) und die zum Flußvektor senkrechte Komponente $i_{\varphi2}$ (Wirkstrom) unabhängig voneinander vorzugeben, so daß über den Magnetisierungsstrom die Stärke des Feldes, über den Wirkstrom das Drehmoment bzw. die Drehzahl eingestellt werden können.

Die hierzu nötige Information über den magnetischen Fluß $\Psi$ kann dadurch gewonnen werden, daß aus den Phasenspannungen der Maschine, die wie der Ständerstrom zu einem Vektor zusammengesetzt werden können, nach Abzug des ohmschen Spannungsabfalles der Vektor der Ständer-EMK der Maschine gebildet wird. Nach Integration und Abzug eines von der induktiven Streuspannung hervorgerufenen Anteiles kann daraus die Lage des Läufer Flußvektors ermittelt werden. Diese als « Spannungsmodell » bezeichnete, vom Spannungsvektor ausgehende Ermittlung des Flusses ermöglicht bei Ständerfrequenzen, die oberhalb etwa 10 % der Nennfrequenz liegen, hinsichtlich Genauigkeit und Dynamik eine befriedigende Regelung. Die beim Spannungsmodell erforderliche Integration benötigt jedoch eine Gleichanteilregelung, die bei tieferen Frequenzen die Genauigkeit der Flußermittlung und die Regeldynamik ungünstig beeinflußt. Außerdem wird für die Berücksichtigung des ohmschen Spannungsabfalles für das Spannungsmodell der Parameter $R^S$ des Ständerwiderstandes benötigt, der bei einer Erwärmung der Maschine temperaturabhängig ist, so daß mit abnehmender Frequenz eine Diskrepanz des tatsächlichen, temperaturabhängigen Ständerwiderstandes von dem im Modell verwendeten Parameter zu immer größeren Fehlern bei der Flußerfassung und damit bei der Regelung führt.

Daher wird bevorzugt bei niedrigen Frequenzen die Flußerfassung mit Hilfe einer Rechenmodellschaltung durch geführt, die von den Ständerströmen und einer Eingabe des Läuferstellungswinkels ausgeht und die Vorgänge in der Maschine, die zur Ausbildung des Flusses führen, elektrisch nachbildet. Für die Funktion dieses « Strommodells » ist jedoch die exakte Kenntnis des Läuferwiderstandes $R^L$ erforderlich. Da der Läuferwiderstand einer Asynchronmaschine besonders temperaturabhängig ist, kann es auch hier zu Fehlern kommen, wenn im Strommodell der Parameter des Läuferwiderstandes auf einem mittleren, temperaturunabhängigen Modellwert eingestellt ist. Dies kann dazu führen, daß die Forderung nach konstantem Fluß nicht erfüllt wird und z. B. ein gefordertes, bestimmtes Anfahrmoment von der Maschine nicht bereitgestellt werden kann. Auch kann es wegen der falschen Flußerfassung zu einer schlechten Maschinenausnutzung und zu Sättigungserscheinungen kommen.

Der Erfindung liegt die Aufgabe zugrunde, auf elektronischem Weg aus leicht meßbaren Größen, wie z. B. Ständerstrom, Spannung und Läuferstellungswinkel, den Wert des Läuferwiderstandes der Maschine möglichst genau zu ermitteln. Diese Aufgabe wird erfindungsgemäß durch das im Anspruch 1 angegebene Verfahren gelöst.

Demnach wird aus den Ständerspannungen und Ständerströmen z. B. den Strangspannungen und Strangströmen der Maschine als erster Vektor der EMK-Vektor der Maschine (« Maschinen-EMK-Vektor ») errechnet. Da der EMK-Vektor e aus der zeitlichen Änderung des Flusses entsteht, kann gleichbedeutend auch $\int e \, dt = \Psi$, der Flußvektor als erster Vektor benutzt werden.

Gleichzeitig mit der Bestimmung des ersten Vektors e bzw. $\Psi$ werden mittels eines elektrischen Rechenmodells (« Strommodell »), das von den Phasenströmen, der Läuferstellung stellung und einem einstellbaren Modellwert für den Läuferwiderstand gespeist ist, die zur Entstehung des magnetischen Feldes in der Maschine führenden Vorgänge nachgebildet. Diesem nachgebildeten Feld kann ein Modell-Flußvektor zugeordnet werden, wobei durch Differentiation des Modellflußvektors ein entsprechender nachgebildeter Modell-EMK-Vektor als zweiter Vektor abgeleitet werden kann. Im allgemeinen ist es bei der Erfindung nicht erforderlich, den Modell-Flußvektor $\Psi_M$ bzw. den Modell-EMK-Vektor $e_M$ in seinen beiden Freiheitsgraden (Bestimmungsgrößen) zu berechnen, vielmehr genügt es, wenn lediglich eine Bestimmungsgröße, z. B. der Flußbetrag $\Psi_M$ bzw. der EMK-Betrag e ermittelt wird. Die beiden Flußvektoren $\Psi$, $\Psi_M$ bzw. die beiden EMK-Vektoren e, $e_M$ stimmen nur dann überein, wenn ihre Bestimmungsgrößen gleich sind, es müssen also z. B. die Vektorbeträge e und $e_M$ bzw. $\Psi$ und $\Psi_M$ übereinstimmen.

Gemäß der Erfindung wird daher zum Vergleich des ersten Vektors mit dem zweiten Vektor eine Bestimmungsgröße des ersten Vektors mit einer entsprechenden Bestimmungsgröße des zweiten Vektors verglichen. Der erwähnte Fall, daß dabei der zweite Vektor selbst gar nicht berechnet werden muß ist z. B. gegeben, wenn als erster Vektor der Maschinen-Flußvektor $\Psi$ und

als seine Bestimmungsgröße der Maschinen-Fluß-betrag $\Psi$ verwendet wird. Als Bestimmungsgröße des entsprechenden zweiten Vektors muß daher im Rechenmodell lediglich der Modell-Flußbetrag $\Psi_M$ berechnet werden, während die Richtung des Modell-Flußvektors $\Psi_M$ nicht benötigt wird. Aus den beiden Bestimmungsgrößen wird die Differenz gebildet.

Die Einstellung des Modellwertes des Läuferwiderstandes wird nun in Abhängigkeit von der Differenz verändert, bis diese Differenz minimal wird. Der bei minimaler Differenz eingestellte Läuferwiderstand-Modellwert kan als ermittelter Wert des Läuferwiderstandes der Maschine verwendet werden.

Die Erfindung geht von der Erkenntnis aus, daß für die Maschine und für das Strommodell wegen des gemeinsamen Stromes deckungsgleiche Kreisdiagramme gelten. Stimmt der Modellwert des Läuferwiderstandes nicht mit dem tatsächlichen Läuferwiderstand überein, so entstehen jedoch unterschiedliche Schlupfskalen. Da die Schlüpfe von Modell und Maschine ungleich sind, treten zum Teil erhebliche Abweichungen des Modellflußvektors vom echten Flußvektor auf. Mit Ausnahme des Leerlaufs ist (unabhängig von der Belastung und der Frequenz) der Modellfluß immer dann größer als der tatsächliche Fluß, wenn der Parameterwert des Läuferwiderstandes größer als der tatsächliche Läuferwiderstand ist. Führt man daher durch eine Veränderung des Widerstandsparameters im Strommodell den Modellfluß dem tatsächlichen Fluß nach, bis praktisch Übereinstimmung zwischen Modellfluß und Maschinenfluß herrscht, so ergibt sich bei Abgleich der beiden Flüsse der tatsächliche Läuferwiderstand als der Wert, der im Strommodell zum abgeglichenen Zustand gehört.

Hierbei ergibt sich die weitere Schwierigkeit, daß der tatsächliche Fluß in der Maschine nicht direkt meßbar ist, wenn man von der Verwendung von Hallsonden absieht. Jedoch kann aus den Strangströmen und Strangspannungen der Vektor der Maschinen-EMK ermittelt werden, der der zeitlichen Ableitung des Maschinenflußvektors entspricht. Die Kenntnis des Läuferwiderstandes ist hierbei nicht erforderlich. Zum Abgleich von Modell und Maschine wird daher gemäß der Erfindung aus den Klemmenspannungen und Ständerströmen eine skalare Größe gebildet, die als Bestimmungsgröße des ersten Vektors der EMK der Maschine zugeordnet ist. Aus dem im Strommodell ermittelten Modellfluß wird die zugehörige skalare Modellgröße gebildet. Der Flußvektor bzw. EMK-Vektor ist ein Vektor mit zwei Bestimmungsgrößen z. B. den Komponenten in einem senkrecht zur Drehachse angeordnetem Koordinatensystem oder Betrag (Länge) des Vektors und Winkellage. Daher kann als Bestimmungsgröße des ersten Vektors der Betrag des Maschinen-EMK-Vektors bzw. des durch Integration daraus enthaltenen Maschinenflußvektors benutzt und mit dem ersprechenden Betrag des Modell-EMK-Vektors bzw. des Modellflußvektors verglichen werden. Es können aber auch jeweils eine Komponente des Maschinen- und Modellvektors miteinander verglichen werden.

In einer ersten Ausführungsform kann als Maschinengröße der Betrag des Maschinenflußvektors verwendet werden, wobei der Maschinen-Flußvektor durch Integration des Maschinen-EMK-Vektors gebildet wird. Der Maschinen-EMK-Vektor seinerseits wird vorteilhaft aus dem Vektor der Ständerspannung nach Abzug des ohmschen Spannungsabfalles und der induktiven Streuspannung ermittelt. Zum Betrag des Maschinen-Flußvektors gehört als skalare Modellgröße der Betrag des im Rechenmodell ermitteln Modell-Flußvektors.

Allerdings bedingt die Integration der Maschinen-EMK bei niedrigen Frequenzen wegen der erforderlichen Gleichanteilregelung einen weiteren Aufwand, wie er z. B. in der nicht vorveröffentlichten Anmeldung « Drehfeldmaschinenantrieb mit einer umrichtergesteuerten Drehfeldmaschine und einer mit zwei Wechselspannungsintegratoren und einer Rechenmodellschaltung verbundenen Umrichtersteuerung » des gleichen Anmelders beschrieben ist.

Bevorzugt ist eine Anwendungsform der Erfindung, bei der von einer Integration des Maschinen-EMK-Vektors abgesehen ist. So können zum Abgleich die Beträge des Maschinen-EMK-Vektors und des Modell-EMK-Vektors verwendet werden. Der Betrag des Modell-EMK-Vektors kann vorteilhaft durch Differenzieren des in der Rechenmodellschaltung ermittelten Flußvektors und anschließende Betragsbildung ermittelt werden.

Damit wird der Läuferwiderstand hinreichend genau ermittelt, wenn gleichzeitig der in die Ermittlung des Maschinen-EMK-Vektors eingehende Wert des Ständerwiderstandes hinreichend genau bekannt ist. Eine Abweichung von etwa 50 % des Ständerwiderstandes ergibt jedoch bei der Ermittlung der Maschinen-EMK einen Fehler von etwa 1 bis 2 % des Nennwertes. Berücksichtigt man ferner, daß die Betragsbildung in der Rechnmodellschaltung einen Fehler der gleichen Größenordnung nicht ausschließt, so kann bei sehr niedrigen Arbeitsfrequenzen, bei denen die EMK ebenfalls nur einige Prozent des Nennwertes beträgt, der resultierende Fehler bei der Ermittlung des Läuferwiderstandes in der Größenordnung von 100 % liegen.

Ist auch bei niedrigen Frequenzen eine hohe Genauigkeit erforderlich, so ist es vorteilhafter, die Blindkomponenten des Maschinen-EMK-Vektors und des im Strommodell ermittelten Modell-EMK-Vektors als skalare Grössen zu verwenden. Unter der Blindkomponente eines EMK-Vektors wird dabei die Komponente des EMK-Vektors verstanden, die senkrecht zum Ständerstromvektor steht. Diese Blindkomponenten zeigen ebenso eine eindeutige Abhängigkeit vom Läuferwiderstand wie die Beträge des EMK-Vektors selbst.

Der ohmsche Ständerspannungsabfall kann als ein Vektor aufgefaßt werden, der sich vom Ständerstromvektor lediglich um den Faktor des Ständerwiderstromvektor lediglich um den Faktor des Ständerwiderstandes unterscheidet. Er ist ein reiner Abfall der Wirkspannungskomponente und liegt somit parallel zum Ständerstromvektor. Daher geht sein Wert nicht in die Bestimmung der Blindkomponenten ein und die Blindkomponenteder Maschinen-EMK-unterscheidet sich nicht von der Blindkomponente eines Summenvektors aus EMK und ohmschen Spannungsabfall. Daher kann zur Bestimmung der Blindkomponente des Maschinen-EMK-Vektors zunächst aus dem Ständerspannungsvektor unter Abzug der induktiven Streuspannung der Summenvektor aus EMK und ohmschen Spannungsabfall der Maschine gebildet werden und dessen Blindkomponente als Blindkomponente des Maschinen-EMK-Vektors zum Vergleich mit der Blindkomponente des Modell-EMK-Vektors herangezogen werden.

Bei dieser Ausführungsform unterscheidet sich dann die Wirkkomponente des Summenvektors der Maschine von der Wirkkomponente des Modell-EMK-Vektors bei erfolgtem Abgleich der Blindkomponenten nur noch um den ohmschen Spannungsabfall der Maschine, der durch das Produkt des Ständerwiderstandes und des Ständerstromes gegeben ist. Daher kann die sich bei minimaler Differenz der Blindkomponenten ergebende Differenz zwischen der Wirkkomponente des Summenvektors und der Wirkkomponente des Modell-EMK-Vektors durch den Betrag des Stromes dividiert und als Wert für den Ständerwiderstand der Maschine abgegriffen werden.

Die Bildung der Blindkomponente eines Vektors geschieht, indem der Vektor in ein mit dem Ständerstrom umlaufendes kartesisches Koordinatensystem transformiert wird. Die eine kartesische Komponente ist dann die Wirkkomponente, die andere Komponente die Blindkomponente des Vektors. Man kann daher den Maschinen-EMK-Vektor (bzw. den Summenvektor) und den Modell-Vektor jeweils getrennt einer Koordinatentransformation unterwerfen und dann die Differenz der Blindkomponenten beider Vektoren bilden, um auf diese Weise zu der skalaren Differenz zu kommen, die für den Abgleich von Maschine und Modell erforderlich ist. Da die Koordinatentransformationen bei der Vektoren mit einem gewissen Fehler behaftet sind, der in die Differenz der durch die Transformation erhaltenen Komponenten entsprechend eingeht, ist diese Differenz ebenfalls nur ungenau ermittelbar. Andererseits kann die Differenz der Blindkomponente zweier Vektoren auch dadurch erhalten werden, daß zuerst die vektorielle Differenz der beiden Vektoren und anschließend durch Koordinatentransformation die Blindkomponente dieses Differenzvektors gebildet wird.

Vorteilhaft wird, entsprechend dieser letzten Möglichkeit, zuerst der Differenzvektor aus dem Maschinen-EMK-Vektor (bzw. dem Summenvektor) und dem Modell-EMK-Vektor gebildet und anschließend die Koordinatentransformation zur Bildung der Blindkomponenten durchgeführt. Zur Ausnutzung des vollen Rechenbereiches für die Koordinatentransformation können dabei die Signale für die der Transformation einzugebenden Komponenten des Differenzvektors über entsprechende Verstärker verstärkt werden, wodurch sich bei geringerem Aufwand die Rechengenauigkeit erhöht.

Die Varianten, bei denen als Bestimmungsgrößen stromorientierte Komponenten der EMK-Vektoren benutzt wurden, lassen sich auch auf den Fall anwenden, daß als erster Vektor nicht der Maschinen-EMK-Vektor e, sondern durch Integration der Maschinen-Flußvektor $\Psi$ verwendet wird. Als zweiter Vektor wird dann der Modell-Flußvektor $\Psi_M$ anstelle des durch Differentiation aus $\Psi_M$ herzuleitenden Modell-EMK-Vektors $e_M$ verwendet. Dabei ist zu beachten, daß der Flußvektor jeweils um 90° gegenüber dem EMK-Vektor verschoben ist. So entsprechen z. B. dem EMK-Blindkomponenten die Fluß-Wirkkomponenten. Durch die Integration des erwähnten Summenvektors wird demnach ein Vektor erhalten, dessen Wirkkomponente sich von der Wirkkomponente des Flußvektors um das Integral des ohmschen Spannungsabfalles unterscheidet. Daher kann in diesem Fall $R^L$ durch einen Wirkomponentenvergleich zwischen dem integrierten Summenvektor und $\Psi_M$ und $R^S$ aus der Blindkomponente des integrierten Summenvektors (d. h. dem Integral der Summenvektor-Wirkkomponente) bestimmt werden.

Anhand von 4 Ausführungsbeispielen, die Vorrichtungen zur Durchführung des Verfahrens erläutern, und 8 Figuren wird die Erfindung näher ausgeführt.

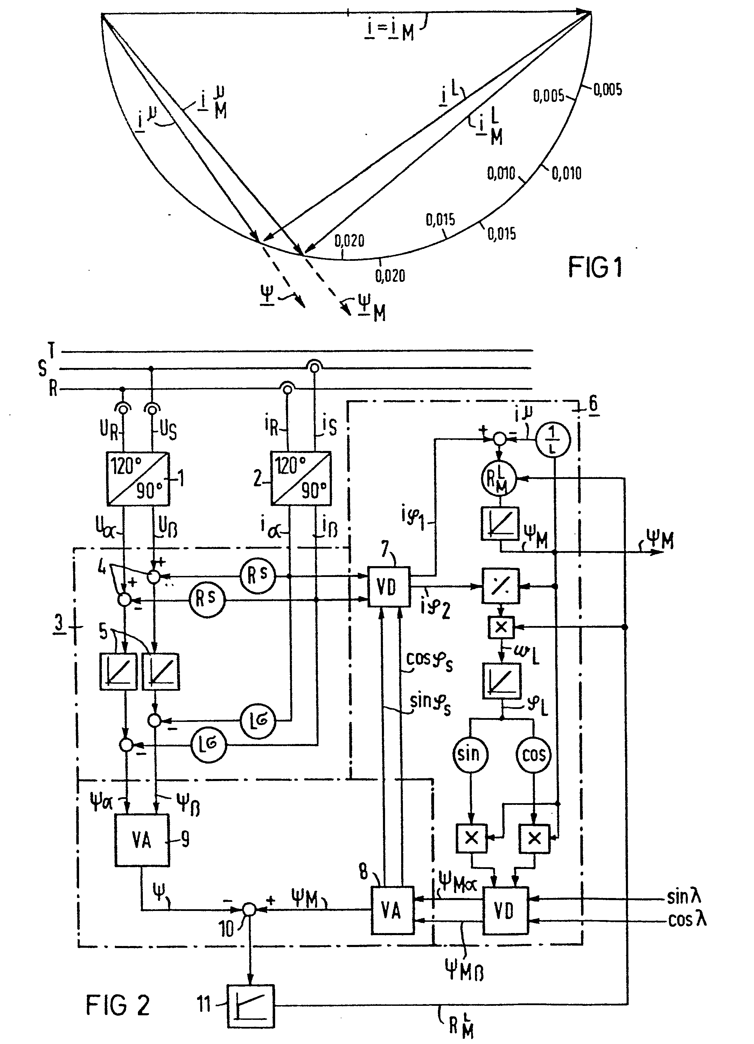

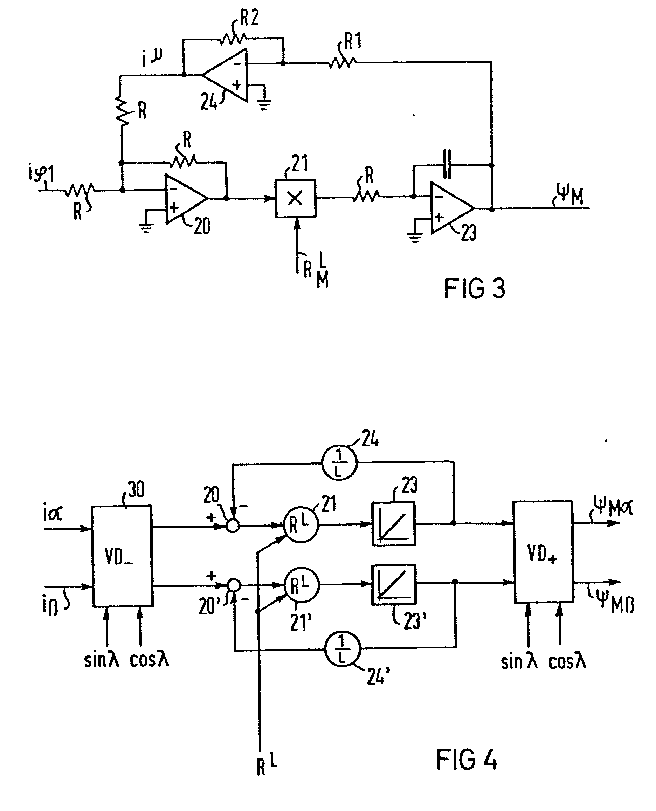

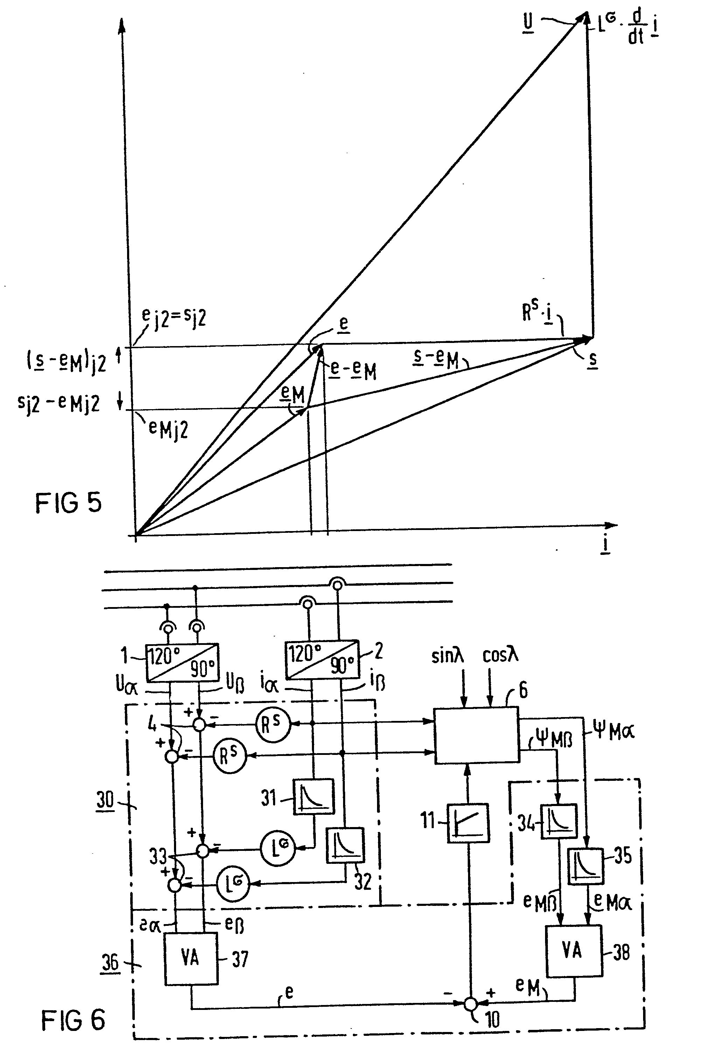

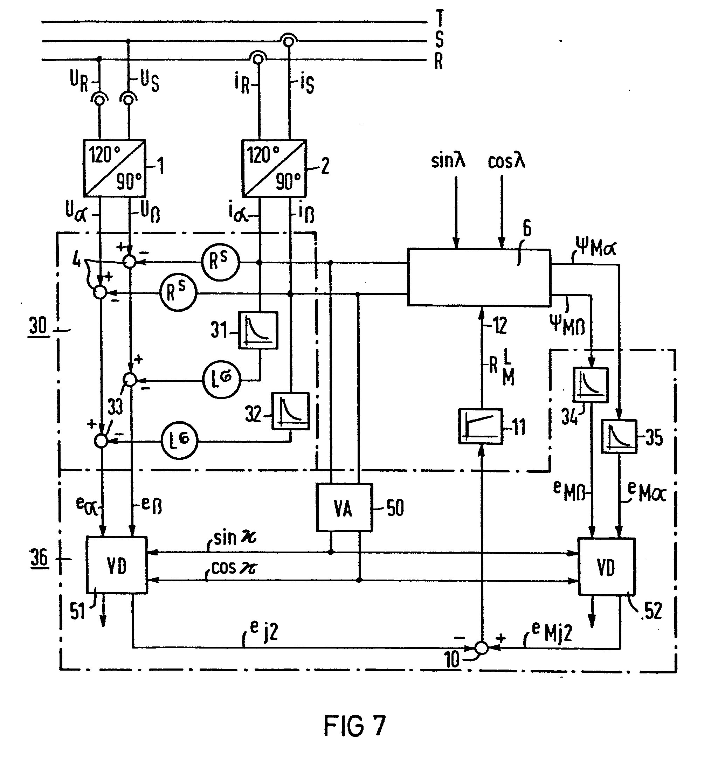

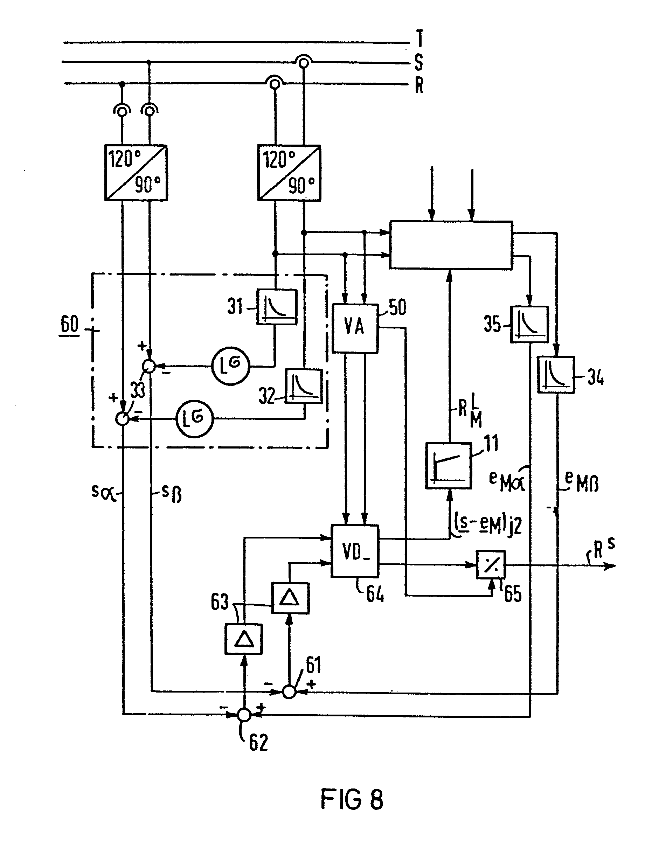

Figur 1 zeigt den Vergleich der Kreisdiagramme für die Asynchronmaschine und das Strommodell. Figur 2 stellt eine erste Ausführungsform der Vorrichtung zur Durchführung des Verfahrens dar, wobei Details der Schaltung in Figur 3 und 4 näher erläutert sind. Figur 5 zeigt ein Vektordiagramm für die EMK-Vektoren des Modells und der Maschine. In Figur 6 ist eine zweite Ausführungsform einer erfindungsgemäßen Vorrichtung sowie ein Schaltungsdetail dargestellt. Die Figuren 7 und 8 betreffen weitere vorteilhafte Ausführungsformen der erfindungsgemäßen Vorrichtung.

Im stationären Zustand steht der Vektor des Magnetisierungsstromes $i^\mu$ der Asynchronmaschine auf dem Vektor des Läuferstrom $i^L$ senkrecht, so daß diese beiden Ströme im Kreisdiagramm nach Figur 1 auf einem Halbkreis über dem der Asyncrhonmaschine eingeprägten Ständerstromvektor i liegen. Für einen gegebenen Läuferwiderstand $R^L$ ergibt sich die auf der Innenseite des Halbkreises angegebene Skala für die Schlupffrequenz, so daß aus dem Kreisdiagramm bei gegebenem Läuferwiderstand die zur jeweiligen Schlupffrequenz gehörenden Vektoren für Magnetisierungsstrom und Läuferstrom abgelesen werden können.

Da das Strommodell von dem gleichen eingeprägten Ständerstrom ausgeht, gilt auch für das Modell das gleiche Kreisdiagramm, jedoch ergeben sich unterschiedliche Schlupfskalen, wenn der Parameter ($R_M^L$) des Läuferwiderstandes im Modell mit dem Läuferwiderstand der Maschine nicht übereinstimmt. In Figur 1 ist an der Außenseite des Halbkreises die Schlupfskala des Modells für den Fall $R_M^L > R^L$ angegeben. Für die Schlupffrequenz von etwa 0,025 ergibt sich dabei der dargestellte Vektor für den Modell-Magnetisierungsstrom $i_M^\mu$, der von dem zur gleichen Schlupffrequenz gehörenden Magnetisierungsstrom $i^\mu$ der Maschine in Lage und Betrag abweicht. Zu den unterschiedlichen Magnetisierungsströmen von Maschine und Modell gehören auch unterschiedliche Vektoren des Flußvektors $\Psi$ bzw. $\Psi_M$. Gemäß der Erfindung werden diese Unterschiede zwischen den Vektoren $\Psi$ und $\Psi_M$ bzw. der entsprechenden EMK-Vektoren e und $e_M$ ausgenutzt, um ein Maß für die Übereinstimmung des Modellparameters $R_M^L$ mit dem tatsächlichen Maschinen Läuferwiderstand $R^L$ zu bilden. Hierzu kann sowohl der Betrag der Vektoren oder auch die Projektion dieser Vektoren auf den Ständerstromvektor i oder eine dazu senkrechte Achse verwendet werden, da zwischen diesen Größen und der Differenz $R_M^L - R^L$ ein eindeutiger, monotoner Zusammenhang besteht. Es wird daher der Läuferwiderstand-Parameter des Modells so lange verändert, bis die beiden Schlupfskalen miteinander deckungsgleich sind, d. h. bis die Vektoren $\Psi$ und $\Psi_M$ zusammenfallen.

Der Fluß der Maschine stellt das Integral der Maschinen-EMK dar und kann bei einer Vorrichtung zur Durchführung des Verfahrens aus zugänglichen Maschinengrößen (Ständerstrom und Phasenspannung) mittels eines EMK-Detektors erfaßt werden. Ferner wird eine Rechenmodellschaltung benötigt, die ebenfalls von den tatsächlichen Maschinenströmen sowie als weitere Information von der Läuferstellung ausgeht und der ein veränderbarer Modellwert $R_M^L$ für den Läuferwiderstand eingebbar ist. Die Rechenmodellschaltung bildet die Vorgänge nach, die in der Maschine zur Erzeugung des Feldes führen und liefert einen dieses Feld im Modell beschreibenden Vektor für den nachgebildeten Fluß. In einer vom EMK-Detektor und der Rechenmodellschaltung gespeisten Rechenstufe werden nun zwei miteinander vergleichbare größen gebildet, von denen die eine eine Bestimmungsgröße des EMK-Vektors der Maschine und die andere eine entsprechende Bestimmungsgröße des durch Differentiation des Flußvektors gebildeten EMK-Vektors des Modells ist. Da es sich bei dem EMK-Vektor bzw. dem Flußvektor um einen ebenen Vektor handelt, der durch Betrag und Winkel oder seine Komponenten in einem gegebenen ebenen Koordinatensystem bestimmt ist, kann es sich bei der Bestimmungsgröße z. B. um den Betrag oder um eine Komponente des Vektors, vorzugsweise bezüglich eines mit dem Ständerstrom rotierenden Bezugsystems, handeln. Beim Ausführungsbeispiel nach Figur 2 werden als Vektoren nicht die EMK-Vektoren von maschine und Modell verwendet, sondern der aus dem Maschinen-EMK-Vektor durch Integration gebildete Maschinen-Flußvektor und der im Strommodell ermittelte Flußvektor des Modells. Durch Differenzbildung wird in der Rechenstufe eine skalare Größe gebildet, die die Differenz dieser Bestimmungsgrößen darstellt. Diese Differenz wird dem Eingang eines Reglers zugeführt, dessen Ausgang mit dem Eingabeeingang für den Läuferwiderstandsparameter der Rechenmodellschaltung verbunden ist.

Bei der Ausführungsform nach Figur 2 werden an den Zuleitungen R, S, T der Asynchronmaschine zwei Klemmenspannungen $U_R$ und $U_S$ und zwei Strangströme $i_R$ und $i_S$ abgegriffen, die den Komponenten des Spannungsstromvektors U bzw. des Ständerstromvektors i in einem von den Wicklungsachsen der entsprechenden Ständerwicklungen mit einem Winkel von 120° aufgespannten Koordinatensystem entsprechen. In Koordinatenwandlern 1, 2 werden diese Vektoren in ein kartesisches, mit dem Ständersystem der Asynchronmaschine ortsfest verbundenes Koordinatensystem transformiert. Im folgenden sind die kartesischen Komponenten eines Vektors in diesem ortsfesten Ständerbezugssystem durch die Indizes $\alpha$ und $\beta$ gekennzeichnet.

Im EMK-Detektor 3, der hier bereits auf die Erfassung des Maschinenflusses ausgelegt ist, wird jeweils von einer Komponente des Spannungsvektors die entsprechende Komponente des Vektors des ohmschen Spannungsabfalles abgezogen, der sich aus der entsprechenden Komponente des Ständerstromvektors durch Multiplikation mit einem auf den Ständerwiderstand $R^S$ der Asynchronmaschine eingestellten Faktor ergibt (Subtraktionsstellen 4). Durch Integration (Integratoren 5) wird daraus der zum EMK-Vektor der Maschine gehörende Flußvektor $\Psi$ gebildet, wobei zur Kompensation der induktiven Streuspannung den Komponenten jeweils noch das Produkt aus der entsprechenden Ständerstromkomponente und einem der Streuinduktivität $L^\sigma$ entsprechenden Faktor subtrahiert wird. Am Ausgang des EMK-Detektors 3 stehen somit die Komponenten $\Psi_\alpha$ und $\Psi_\beta$ des Flußvektors der Maschine im Ständerbezugssystem an.

Ferner ist eine Rechenmodellschaltung 6 vorgesehen, die ein Strommodell der Asynchronmaschine darstellt und von den Komponenten $i_\alpha$ und $i_\beta$ des Ständerstromes sowie einer Läuferstellungseingabe sin $\lambda$, cos $\lambda$ beaufschlagt ist, wobei $\lambda$ der Winkel der Läuferachse bezüglich einer Koordinat des Ständerbezugssystems darstellt. Am Ausgang dieses Strommodells steht der Modell-Flußvektor $\Psi_M$ in Form seiner beiden kartesischen, ständerbezogenen Koordinaten $\Psi_{M\alpha}$ und $\Psi_{M\beta}$ an. Es könnte aber auch genügen, lediglich den Flußvetrag $\Psi$ aus der Rechenmodellschaltung herauszuführen.

Bei der in Figur 2 schematisch dargestellten Rechenmodellschaltung für das Strommodell werden zunächst die ständerbezogenen Komponenten des Ständerstromvektors in einem Vektordreher 7 in ein mit dem FLußvektor umlaufendes «feldorientiertes» Koordinatensystem transformiert. Im folgenden ist mit dem Index $\varphi1$ jeweils die zum Flußvektor $\Psi$ parallele Komponente eines Vektors, mit dem Index $\varphi_2$ die dazu senkrechte Komponente eines Vektors bezeichnet. Das feldorientierte Koordinatensystem geht aus dem ständerbezogenen Koordinatensystem durch eine Drehung hervor, die durch den Winkel $\varphi_S$ des Flußvektors im ständerbezogenen Koordinatensystem bestimmt ist.

Im stationären Zustand ist die feldparallele Komponente $i_{\varphi1}$ des Ständerstromes gleich dem Magnetisierungsstrom $i^\mu$ der Asynchronmaschine. Bei dynamischen Vorgängen jedoch ergibt sich ein Überschuß von $i_{\varphi1}$ über den Magnetisierungsstrom $i^\mu$, der zu einer Änderung der Feldstärke in der Maschine führt. Daher wird in der Rechenmodellschaltung zunächst die Differenz $i_{\varphi1}-i^\mu$ gebildet, aus der Multiplikation mit dem Parameterwert des Läuferwiderstandes die Änderung der Feldstärke und durch anschließende Integration die Feldstärke selbst, d. h. der Betrag des Flußvektors gebildet wird. Da der Betrag des Flußvektors durch das Produkt aus Magnetisierungsstrom $i^\mu$ und der Hauptfeldinduktivität L der Maschine gegeben ist, kann der benötigte Wert für den Magnetisierungsstrom $i^\mu$ am Ausgang des Integrators über einen Multiplizierer (Multiplikationsfaktor 1/L) abgegriffen werden.

Durch Bildung des Quotienten $i_{\varphi2}/\Psi_M$ anschließende Multiplikation mit $R_M^L$ wird sodann die zur Wirkstromkomponente des Ständerstromes und dem gegebenen Modellfluß $\Psi_M$ gehörende Schlupffrequenz (Winkelgeschwindigkeit $\omega_L$) gebildet. Durch Integration entsteht der Winkel $\varphi_L$ zwischen Flußvektor und Läuferwicklungsachse. Mittels Winkelfunktionsgeneratoren und Multiplikation mit dem Betrag $\Psi_M$ des Modellflusses werden sodann die Komponenten des Modellflußvektors in dem mit der Läuferachse umlaufenden Läuferbezugssystem gebildet, die durch Koordinatentransformation in das Ständerbezugssystem zurücktransformiert werden. Hierzu wird ein weiterer Vektordreher benötigt, der von entsprechenden Läuferstellungseingaben sin $\lambda$, cos $\lambda$ beaufschlagt ist.

Die Komponenten $\Psi_\alpha$, $\Psi_\beta$ bzw. $\Psi_{M\alpha}$, $\Psi_{M\beta}$ werden in Vektoranalysatoren 8, 9 eingegeben, die daraus jeweils den Betrag $\Psi$ bzw. $\Psi_M$ des Maschinen-Flußvektors und des Modell-Flußvektors bilden. Ein derartiger Vektoranalysator liefert aus den kartesischen Komponenten eines Vektors den Betrag sowie Cosinus und Sinus des Winkels, so daß die entsprechende Winkelinformation des Vektoranalysators 8 dem Vektoranalysator 7 am Eingang der Rechenmodellschaltung 6 eingegeben werden kann.

Die Differenz der skalaren Größen $\Psi$ und $\Psi_M$ (Subtraktionsstufe 10) kann nun als entsprechende Regelabweichung zur Nachstellung des Läuferwiderstandes-Parameters $R_M^L$ der Rechenmodellschaltung verwendet werden, da $\Psi_M - \Psi$ proportional zu $R_M^L - R^L$ ist. Hierzu ist ein der Subtraktionsstelle 10 nachgeschalteter Regler 11 vorgesehen, dessen Eingang an diejenigen Stellen der Rechenmodellschaltung 6 angeschlossen ist, an denen eine Multiplikation mit $R_M^L$ vorgesehen ist.

Der entscheidende Vorgang in der Rechenmodellschaltung 6 ist die Bildung des Betrages $\Psi_M$ des Modellflußvektors aus dem Ständerstrom $i_{\varphi1}$ und dem Parameterwert $R_M^L$. Eine schaltungsmäßige Realisierung ist in Figur 3 genauer erläutert. Dabei werden einem Verstärker 20 zur Bildung von $i_{\varphi1} - i^\mu$ zunächst entsprechende Spannungen aufgeschaltet und dessen Ausgangssignal an einen Multiplizierer 21 mit dem eingegebenen Modellparameter $R_M^L$ multipliziert. Hieran schließt sich ein Integrator 23 an, an dessen Ausgang der Betrag $\Psi_M$ des Modellflußvektors ansteht. Die Ausgangsspannung des Integrators 23 wird ferner über einen Verstärker 24, dessen Widerstandsbeschaltung durch R1/R2 = L gegeben ist, dem Eingang des Verstärkers 20 als entsprechende Spannung $i^\mu$ rückgeführt.

Das soeben beschriebene Strommodell löst die Differentialgleichung der Asynchronmaschine im feldorientierten Koordinatensystem. Man kann die Differentialgleichung aber auch im läuferbezogenen Bezugssystem lösen. Eine hierzu geeignete Rechenmodellschaltung ist in Figur 4 angegeben. Dazu wird der im Ständerbezugssystem gegebene Ständerstromvektor mittels eines ersten Vektordrehers 30, der von der Läuferstellung $\lambda$ bzw. entsprechenden Winkelfunktionen sin $\lambda$, cos $\lambda$ im Ständerbezugssystem gespeist ist, in ein mit der Läuferachse umlaufendes Bezugssystem transformiert. Da der Magnetisierungsstrom $i^\mu$ stets zum Flußvektor parallel ist und daher im feldorientierten Bezugssystem nur eine $\varphi1$-Komponente hat, im läuferbezogenen System durch zwei Komponenten beschrieben werden muß, ist bei der Schaltung nach Figur 4 abweichend von der Schaltung nach Figur 3 nunmehr für die Lösung der Differentialgleichung für jede der beiden läuferbezogenen Komponenten des Ständerstromes un des Magnetisierungsstromes eine Schaltung nach Figur 3 erforderlich. Die hierzu nötigen Schaltungselemente sind in Figur 4 analog zur Figur 3 mit den Bezugszeichen 20 bis 24 und 20' bis 24' versehen. Dadurch werden jetzt die Komponenten des Flußvektors $\Psi_M$ im läuferbezogenen Bezugssystem gebildet, die anschließend in einem Vektordreher 31 entsprechend der Läuferstellung von dem läuferbezogenen Bezugssystem im das ständerbezogene Bezugssystem rücktransformiert werden. Die dabei gebildeten ständerbezogenen Komponenten $\Psi_{M\alpha}$ und $\Psi_{M\beta}$ können nunmehr dem Vektoranalysator 8 in Figur 2 eingegeben werden.

Zur weiteren Veranschaulichung des Verfahrens ist in Figur 5 der Ständerstromvektor i und der Spannungsvektor U angegeben. Der EMK-Vektor e der Maschine läßt sich vektoriell darstellen als $e = U - L^\sigma \cdot (d/dt)(i) - R^S i^S$. Ferner ist der entsprechende Modell-EMK-Vektor e angegeben, der sich im Strommodell bei einem Parameter $R_M^L < R^L$ ergibt. Die Beträge e, $e_M$ dieser beiden EMK-Vektoren können wegen der Proportionalität zwischen $e_M - e$ und $R_M^L - R^L$ ebenfalls zum Nachführen des Modellparameterwertes in der Rechenmodellschaltung verwendet werden. Ebenso können aber auch die Projektionen der Vektoren e, $e_M$ auf eine zum Ständerstromvektor i senkrechte Achse, d. h. die mit $e_{j2}$ und $e_{Mj2}$ bezeichneten Blindkomponenten dieser Vektoren herangezogen werden, da für sie die gleiche Proportionalität gilt. Diese beiden Varianten werden bei den Ausführungsformen nach den Figuren 6 und 7 verwendet. Ferner ergibt sich aus Figur 5, daß die Blindkomponente $e_{j2}$ des Maschinen-EMK-Vektors e gleich der Blindstromkomponente $s_{j2}$ eines Summenvektors $s = e + R^S \cdot i$ ist, der sich aus dem Ständerspannungsvektor U und der induktiven Streuspannung gemäß $s = U - L \cdot (d/dt)(i)$ ergibt. Dieser Zusammenhang ist bei der Ausführungsform nach Figur 8 benutzt.

Außerdem kann man Figur 5 entnehmen, daß die Differenz der Blindkomponenten $(e_{j2} - e_{Mj2}$ bzw. $s_{j2} - e_{Mj2})$ der Vektoren e und $e_M$ bzw. s und $e_M$ gleich der Blindkomponente des Differenzvektors $e - e_M$ bzw. $s - e_M$ ist. Diese Vertauschbarkeit von Differenzbildung und Blindkomponentenbildung wird ebenfalls im Zusammenhang mit Figur 8 ausgenutzt.

Bei der Vorrichtung nach Figur 6 sind analog zu Figur 2 Koordinatenwandler 1 und 2, eine Rechenmodellschaltung 6, wie sie im Zusammenhang mit Figur 3 oder 4 beschrieben ist, sowie ein Regler 11 vorgesehen, der dem Eingabeeingang 12 für den Läuferwiderstand-Parameter $R_M^L$ vorgeschaltet ist. Im EMK-Detektor 30 ist abweichend von Figur 2 nicht die Integration des Maschinen-EMK-Vektors zum Flußvektor vorgesehen, vielmehr werden nach der Bildung von $U - R^S \cdot i$ (Subtraktionsstellen 4) die Komponenten $e_\alpha$ und $e_\beta$ des Maschinen-EMK-Vektors e in den ständerbezogenen Koordinaten dadurch gebildet, daß mittels der Differenzierglieder 31 und 32 für die Ständerstromkomponenten $i_\alpha$ und $i_\beta$ an den Subtraktionsstellen 33 ohne vorhergehende Integration der Streuspannungsabfall $L^\sigma \cdot (d/dt)(i_\alpha)$ und $L^\sigma \cdot (d/dt)(i_\beta)$ berücksichtigt wird. Um aus dem im Strommodell ermittelten Modellflußvektor $\Psi_M$ als vergleichbare Größe den Modell-EMK-Vektor $e_M$ zu erhalten, werden die Komponenten $\Psi_{M\alpha}$ und $\Psi_{M\beta}$ differenziert (Differenzierglieder 34 und 35).

Ferner muß in der Rechenstufe 36 eine skalare Größe gebildet werden, die dem Regler 11 für den Abgleich des Läuferwiderstands-Parameters eingegeben werden kann. Hierzu ist der Betrag der beiden EMK-Vektoren vorgesehen. Die Betragsbildung geschieht im vorliegenden Fall dadurch, daß die Vektoren e und $e_M$ jeweils Vektoranalysatoren 37 und 38 zugeführt werden, deren dem Vektorbetrag entsprechende Ausgänge der Subtraktionsstufe 10 am Reglereingang zugeführt sind.

Nach Figur 7 werden zur Bildung der skalaren Eingangsgröße für den Regler 11 anstelle der Vektorbeträge deren Blindkomponenten $e_{j2}$ bzw. $e_{Mj2}$ herangezogen. Die Bildung der Blindkomponenten kann vorteilhaft dadurch geschehen, daß die Komponenten $i_\alpha$ und $i_\beta$ einem Vektoranalysator 50 zugeführt werden. Von den Ausgangsgrößen des Vektoranalysators 50 wird lediglich die Information über die Winkellage des Ständerstromvektors benötigt, um die entsprechenden Signale sin κ und cos κ Vektordrehern 51 und 52 zuzuführen, mit deren Hilfe die EMK-Vektoren e und $e_M$ auf das mit dem Ständerstromvektor rotierende Bezugssystem transformiert werden. Von den Ausgangsgrößen der Vektordreher 51 und 52 werden jeweils wiederum nur die zum Ständerstromvektor senkrechten Komponenten, d. h. die Blindstromkomponenten $e_{j2}$, $e_{Mj2}$ benötigt, die der Subtraktionsstelle 10 zugeführt sind.

Wie bereits eingangs erwähnt wurde, ist es vorteilhaft, die Blindkomponentenbildung und die Differenzbildung miteinander zu vertauschen. In diesem Falle werden die Vektoren e und $e_M$ komponentenweise subtrahiert und der entstehende Differenzvektor in einem Vektordreher der Koordinatentransformation unterworfen, wobei dann nur die Blindkomponente des Differenzvektors als skalare Eingangsgröße für den Regler 11 verwertet wird.

Bei dem Ausführungsbeispiel nach Figur 8 ist diese Vertauschung der Blindkomponentenbildung und der Differenzbildung durchgeführt. Die Komponenten $e_{M\alpha}$, $e_{M\beta}$ des Modell-EMK-Vektors $e_M$ werden analog zu Figur 7 gebildet. Als Bestimmungsgröße für den Maschinen-EMK-Vektor wird wiederum dessen Blindstromanteil verwendet, der jedoch in diesem Fall als Blindkomponente des erwähnten Summenvektors $s = e + R^S \cdot i$ gewonnen wird. Hierzu werden die Ständerbezogenen Komponenten $s_\alpha$, $s_\beta$ dieses Summenvektors s dadurch gebildet, daß von dem Ständerspannungsvektor (Komponenten $U_\alpha$, $U_\beta$) lediglich die induktive Streuspannung abgezogen wird und auf eine Berücksichtigung des ohmschen Ständerwiderstandes (Subtraktionsstellen 4 in den Figuren 2, 6 und 7) verzichtet wird. An den Subtraktionsstellen 61 und 61 wird der im EMK-Detektor 60 ermittelte Vektor s von dem Modell-EMK-Vektor e komponentenweise subtrahiert. Die Komponenten des entstehenden Differenzvektors werden über Verstärker 63 einem Vektordreher 64 eingegeben, der wie in Figur 7 von den Winkelgrößen des Vektoranalysators 50 beaufschlagt ist. Die Blindkomponente $(s - e_M)_{j2}$ des Differenzvektors wird den Eingang des Reglers 11 zugeführt.

Für manche Anwendungen ist es vorteilhaft, auch eine Information über den Ständerwiderstand $R^S$ der Asynchronmaschine zu erhalten. Dies kann bei der Ausführung nach Figur 8 auf einfache Weise dadurch geschehen, daß die Wirkkomponente des Differenzvektors $(s - e_M)$ dem Dividendeneingang eines Dividierers 65 zugeführt ist, dessen Divisoreingang der im Vektoranalysator 50 ermittelte Betrag des Ständerstromes aufgeschaltet ist. Am ausgang dieses Dividierers 65 kann dann der Ständerwiderstand $R^S$ abgegriffen werden.

Gemäß der Beziehung $\Psi = \int e \, dt$ können bei den Ausführungsbeispielen nach den Figuren 6 bis 8 die Differenzierglieder 34 und 35 auch weggelassen werden, sofern Integratoren entsprechend den Integratoren 5 in Figur 2 im EMK-Bildner vorgesehen oder dem EMK-Bildner nachgeschaltet sind. Dadurch wird von der Verwendung von $e$ und $e_M$ auf die Verwendung der Vektoren $\Psi$ und $\Psi_M$ als erster und zweiter Vektor übergegangen. Wegen der dabei auftretenden Drehung um 90° müssen lediglich noch bei den Vektordrehern 51 und 52 die Zuordnung der Ausgänge so vertauscht werden, daß der Blindkomponente (Index j2) der EMK-Vektoren jetzt die Wirkkomponente (Index j1) der Flußvektoren entspricht. Im übrigen bleiben die Schaltungen unverändert.

**Ansprüche**

1. Verfahren zum Ermitteln des Läuferwiderstandes ($R^L$) einer Asynchronmaschine, dadurch gekennzeichnet, daß ein der EMK der Maschine zugeordneter erster Vektor bestimmt wird, indem aus Ständerspannungen ($U_R$, $U_S$) und Ständerströmen ($i_R$, $i_S$) der EMK-Vektor ($e_\alpha$, $e_\beta$) oder der Flußvektor ($\Psi_\alpha$, $\Psi_\beta$) errechnet wird,

— ein einem Rechenmodell (6) zugeordneter Flußvektor ($\Psi_{M\alpha}$, $\Psi_{M\beta}$) gebildet wird, wobei das Rechenmodell von den Ständerströmen, der Läuferstellung (sin $\lambda$, cos $\lambda$) der Maschine und einem einstellbaren Modellparameter ($R_M^L$) für den Läuferwiderstand ($R^L$) ausgeht und die Dynamik der zur Entstehung des magnetischen Flusses der Maschine führenden Vorgänge nachbildet,

— die Differenz zweier Größen gebildet wird, wobei die eine Größe eine Bestimmungsgröße des der Maschine zugeordneten, ersten Vektors (« bestimmende Maschinengröße ») ist und die zweite Größe (« bestimmend Modellgröße ») eine entsprechende Bestimmungsgröße eines aus dem nachgebildeten Flußvektor ableitbaren zweiten Vektors, ist, und

— die Einstellung des Modellparameters ($R_M^L$) verändert wird, bis die Differenz minimal ist, wobei der bei minimaler Differenz eingestellte Modellparameter ($R_M^L$) dem zu ermittelnden Läuferwiderstand ($R^L$) der Maschine gleichgesetzt wird (Fig. 6 bzw. 2).

2. Verfahren nach Anspruch 1, dadurch gekennzeichnet, daß als bestimmende Maschinengröße der Betrag ($\Psi$) des durch Integration des Maschinen-EMK-Vektors gebildeten Maschinen-Flußvektors ($\Psi_\alpha$, $\Psi_\beta$) und als bestimmende Modellgröße der Betrag ($\Psi_M$) des nachgebildeten Flusses verwendet werden (Fig. 2).

3. Verfahren nach Anspruch 1, dadurch gekennzeichnet, daß als Bestimmungsgrößen die Beträge ($e$, $e_M$) des Maschinen-EMK-Vektors ($e_\alpha$, $e_\beta$) und eines aus dem nachgebildeten Flußvektor ($\Psi_{M\alpha}$, $\Psi_{M\beta}$) errechneten, als zweiter Vektor dienenden Modell-EMK-Vektors ($e_{M\alpha}$, $e_{M\beta}$) verwendet werden (Fig. 6).

4. Verfahren nach Anspruch 3, dadurch gekennzeichnet, daß der Betrag ($e_M$) des Modell-EMK-Vektors ($e_{M\alpha}$, $e_{M\beta}$) durch Differenzieren (Differenzierer 34, 35) des aus dem nachgebildeten Fluß berechneten Flußvektors ($\Psi_{M\alpha}$, $\Psi_{M\beta}$) und anschließende Betragsbildung (Vektoranalysator 38) ermittelt wird (Fig. 6).

5. Verfahren nach einem der Ansprüche 2 bis 4, dadurch gekennzeichnet, daß der Maschinen-EMK-Vektor ($e_\alpha$, $e_\beta$) aus dem Vektor der Ständerspannung ($U_\alpha$, $U_\beta$) nach Abzug des ohmschen Spannungsabfalls und der induktiven Streuspannung ermittelt wird (Fig. 6).

6. Verfahren nach Anspruch 1, dadurch gekennzeichnet, daß als Bestimmungsgrößen die Blindkomponenten ($e_{j2}$, $e_{Mj2}$) des als erster Vektor dienenden Maschinen-EMK-Vektors ($e_\alpha$, $e_\beta$) und eines aus dem nachgebildeten Flußvektor errechneten Modell-EMK-Vektors ($e_{M\alpha}$, $e_{M\beta}$) (Fig. 7) bzw. die Wirkkomponente des als erster Vektor dienenden Maschinenflußvektors und eines aus dem nachgebildeten Fluß berechneten, als zweiter Vektor dienenden Modellflußvektors verwendet werden.

7. Verfahren nach Anspruch 6, dadurch gekennzeichnet, daß die Blindkomponente des Maschinen-EMK-Vektors durch Bildung der Blindkomponente des Summenvektors (Komponenten $s_\alpha$, $s_\beta$, Fig. 8) aus Maschinen-EMK-Vektor und ohmschem Spannungsabfall bzw. die Wirkkomponente des Maschinen-Flußvektors aus dem Integral der Summenvektor-Blindkomponente ermittelt wird, wobei dieser Summenvektor aus der Differenz der Ständerspannung und der induktiven Streuspannung gebildet wird (Fig. 8).

8. Verfahren nach Anspruch 7, dadurch gekennzeichnet, daß als weitere Differenz auch die Differenz der anderen Komponente des ersten und des zweiten Vektors gebildet wird, daß diese weitere Differenz durch den Betrag des Ständerstromes dividiert wird und daß der sich bei minimaler weiterer Differenz ergebende Wert als Wert des Ständerwiderstandes (RS) abgegriffen wird (Fig. 8).

9. Verfahren nach einem der Ansprüche 6 bis 8, dadurch gekennzeichnet, daß die Differenz der Blindkomponenten oder Wirkkomponenten der Vektoren durch Bildung der Blindkomponente bzw. Wirkkomponente der Differenz der Vektoren gebildet wird (Fig. 8).

10. Vorrichtung zur Durchführung des Verfahrens nach einem der Ansprüche 1 bis 9, gekennzeichnet durch

a) einen von den Phasenströmen ($i_\alpha$, $i_\beta$) und Phasenspannungen ($U_\alpha$, $U_\beta$) beaufschlagten EMK-Detektor (30) zur Bildung eines der EMK der Maschine zugeordneten ersten Vektors (Komponenten $e_\alpha$, $e_\beta$),

b) eine von den Phasenströmen ($i_\alpha$, $i_\beta$) und einem Läuferstellungssignal (sin $\lambda$, cos $\lambda$) beaufschlagten Rechenmodellschaltung (6), die die zur Ausbildung des Flusses der Maschine führenden Vorgänge unter Berücksichtigung der Maschinenparameter nachbildet, mit einem Eingabeeingang für den Parameter ($R_M^L$) des Läuferwiderstandes der Maschine und einem Ausgang für ein dem Betrag des nachgebildeten Flusses entsprechendes Ausgangssignal oder für den Vektorkomponenten ($\Psi_{M\alpha}$, $\Psi_{M\beta}$) des nachge-

bildeten Flusses entsprechende Ausgangssignale,

c) eine Rechenstufe (36), die eine den Maschinen-EMK-Vektor bestimmende skalare Größe (e) und eine entsprechende, einen zum nachgebildeten Fluß (Komponenten $\Psi_{M\alpha}$, $\Psi_{M\beta}$) gehörenden zweiten Vektor (Komponenten $e_{M\alpha}$, $e_{M\beta}$) bestimmende skalare Größe ($e_M$) ermittelt, und

d) einen Regler (11), dessen Eingang die Differenz (Subtraktionsstelle 10) der in der Rechenstufe ermittelten Bestimmungsgrößen zugeführt ist und dessen Ausgang mit dem Eingabeeingang der Rechenmodellschaltung (6) verbunden ist (Fig. 6).

11. Vorrichtung nach Anspruch 10, dadurch gekennzeichnet, daß der Maschinen-EMK-Vektor im EMK-Detektor (30) und der Modell-Flußvektor in der Rechenmodellschaltung (6) durch Bestimmung ihrer Komponenten in einem vorgegebenen Bezugssystem ermittelbar sind, daß entweder die Rechenstufe (36) Differenzierer (34, 35) für die komponentenweise Differentiation des Modellflußvektors enthält oder der EMK-Detektor Integratoren zur komponentenweisen Integration des Maschinen-EMK-Vektors enthält, und daß die Rechenstufe (36) ferner eine Einrichtung (37, 38) enthält, die aus den Komponenten des Maschinen-EMK-Vektors und des differenzierten Modell-Flußvektors bzw. des integrierten Maschinen-EMK-Vektors und des Modell-Flußvektors die Differenz der Vektorbeträge ermittelt (Fig. 6).

12. Vorrichtung nach Anspruch 10, dadurch gekennzeichnet, daß im EMK-Detektor (30) der Maschinen-EMK-Vektor und in der Rechenmodellschaltung (6) der Modell-Flußvektor komponentenweise bezüglich eines vorgegebenen Koordinatensystems ermittelbar sind, daß entweder die Rechenstufe (36) Differenzierer (34, 35) zur komponentenweisen Differentiation des Modell-Flußvektors enthält oder der EMK-Detektor Integratoren zur komponentenweisen Integration des Maschinen-EMK-Vektors enthält, und daß die Rechenstufe (36) ferner einen von den Ständerströmen beaufschlagten Vektoranalysator (50) zur Bildung von die Lage des Ständerstromvektors in diesem Koordinatensystem beschreibenden Stromwinkelgrößen (sin $\kappa$, cos $\kappa$) sowie eine von den Stromwinkelgrößen beaufschlagte Einrichtung (51, 52) enthält, die durch Transformation der Koordinaten die zum Ständerstromvektor senkrechten Komponenten ($e_{j2}$, $e_{Mj2}$) des Maschinen-EMK-Vektors und des differenzierten Modell-Flußvektors bzw. die zum Ständerstromvektor parallelen Komponenten des integrierten Maschinen-EMK-Vektors und des Modell-Flußvektors bildet und dem Eingang des Reglers 11 zur Differenzbildung der skalaren Bestimmungsgrößen zuführt (Fig. 7).

13. Vorrichtung nach Anspruch 12, dadurch gekennzeichnet, daß der EMK-Detektor (60) anstelle des EMK-Vektors den Summenvektor (Komponenten $s_\alpha$, $s_\beta$) aus Maschinen-EMK-Vektor und ohmschen Spannungsabfall bildet, indem von den Komponenten ($U_\alpha$, $U_\beta$) des Spannungsvektors lediglich das Produkt aus einer der Streuinduktivität ($L^\sigma$) der Maschine entsprechenden Größe und der zeitlichen Ableitung (Differenzierer 31, 32) der Ständerstromkomponenten ($i_\alpha$, $i_\beta$) abgezogen wird (Fig. 8).

14. Vorrichtung nach Anspruch 12 oder 13, dadurch gekennzeichnet, daß die Differenz der Komponenten der beiden Vektoren gebildet ist, indem die Komponenten des einen Vektors je einem Verstärker (63) zugeführt sind, dem die entsprechende Komponente des anderen Vektors subtraktiv aufgeschaltet ist, und daß die Ausgänge der Verstärker (63) der Einrichtung (64) zur Koordinatentransformation zugeführt sind.

15. Vorrichtung nach der Kombination der Ansprüche 13 und 14, dadurch gekennzeichnet, daß in der Einrichtung zur Koordinatentransformation (64) auch die andere Komponente des eingegebenen Vektors ermittelt und dem Dividendeneingang eines Dividierers (65) zugeführt ist, daß der vom Ständerstrom beaufschlagte Vektoranalysator (50) auch den Betrag des Ständerstromes ermittelt und dem Divisoreingang des Dividierers (65) zuführt und daß am Ausgang des Dividierers (65) der Wert für den Ständerwiderstand ($R^S$) der Maschine abgegriffen ist.

**Claims**

1. A process for determining the rotor impedance ($R^L$) of an asynchronous machine, characterised in that a first vector assigned to the EMK of the machine is determined in that the EMK-vector ($e_\alpha$, $e_\beta$) or the flux vector ($\Psi_\alpha$, $\Psi_\beta$) is calculated from stator voltages ($U_R$, $U_S$) and stator currents ($i_R$, $i_S$) ;
— a flux vector ($\Psi_{M\alpha}$, $\Psi_{M\beta}$) assigned to a calculation model (6) is formed, where the calculation model is based upon stator currents, the rotor setting (sin $\lambda$, cos $\lambda$) of the machine, and an adjustable model parameter ($R_M^L$) for the rotor impedance ($R^L$) and simulates the dynamics of the procedures which lead to the formation of the magnetic flux of the machine ;
— the difference between two values is formed, where the first value is a determinant of the first vector assigned to the machine (« determining machine value ») and the second value (« determining model value ») is a corresponding determinant of a second vector which can be derived from the simulated flux vector ; and
— the setting of the model parameter ($R_M^L$) is changed until the difference is minimal, where the model parameter ($R_M^L$) which is set when the difference is minimal is equated with the machine rotor impedance ($R^L$) which is to be determined (Figs. 6 and 2).

2. A process as claimed in Claim 1, characterised in that the amount ($\Psi$) of the machine flux vector ($\Psi_\alpha$, $\Psi_\beta$) formed by integration of the machine EMK-vector is used as the determining machine value and the amount ($\Psi_M$) of the simulated flux is used as the determining model value (Fig. 2).

3. A process as claimed in Claim 1, characterised in that the amounts of the machine EMK-vector ($e_\alpha$, $e_\beta$) and of a model EMK-vector ($e_{M\alpha}$, $e_{M\beta}$) which is calculated from the simulated flux vector ($\Psi_{M\alpha}$, $\Psi_{M\beta}$) and which serves as second vector are used as determinants (Fig. 6).

4. A process as claimed in Claim 3, characterised in that the amount ($e_M$) of the model EMK-vector ($e_{M\alpha}$, $e_{M\beta}$) is determined by differentiating (differentiators 34, 35) the flux vector ($\Psi_{M\alpha}$, $\Psi_{M\beta}$) calculated from the simulated flux and subsequent amount formation (vector analyser 38) (Fig. 6).

5. A process as claimed in one of Claims 2 to 4, characterised in that the machine-EMK-vector ($e_\alpha$, $e_\beta$) is determined from the vector of the stator voltage ($U_\alpha$, $U_\beta$) following the deduction of the ohmic voltage drop and the inductive stray voltage (Fig. 6).

6. A process as claimed in Claim 1, characterised in that the determinants consist of the reactive components ($e_{j2}$, $e_{Mj2}$) of the machine EMK-vector ($e_\alpha$, $e_\beta$) which serves as first vector and a model EMK-vector ($e_{M\alpha}$, $e_{M\beta}$) (Fig. 7) calculated from the simulated flux vector or, as the case may be, of the active component of the machine flux vector which serves as first vector and a model flux vector which is calculated from the simulated flux and which serves as second vector.

7. A process as claimed in Claim 6, characterised in that the reactive component of the machine EMK-vector is determined by forming the reactive component of the sum vector (components $s_\alpha$, $s_\beta$) (Fig. 8) of the machine EMK-vector and the ohmic voltage drop or, as the case may be, the active component of the machine flux vector from the integral of the sum vector reactive component, where this sum vector is formed from the difference between the stator voltage and the inductive stray voltage (Fig. 8).

8. A process as claimed in Claim 7, characterised in that by way of further difference the difference of the other component of the first and second vectors is formed, but this further difference is divided by the amount of the stator current and that the value which occurs in the case of the minimal further difference is used as value of the stator resistance ($R^S$) (Fig. 8).

9. A process as claimed in one of Claims 6 to 8, characterised in that the difference of the reactive components or active components of the vectors is formed by forming the reactive component or active component, as the case may be, of the difference between the vectors (Fig. 8).

10. A device for carrying out the process claimed in one of Claims 1 to 9, characterised by :

a) a EMK-detector (30) which is supplied with the phase currents ($i_\alpha$, $i_\beta$) and phase voltages ($U_\alpha$, $U_\beta$) and which serves to form a first vector (components $e_\alpha$, $e_\beta$) assigned to the EMK of the machine,

b) a calculator model circuit (6) which is supplied with the phase currents ($i_\alpha$, $i_\beta$) and a rotor setting signal (sin $\lambda$, cos $\lambda$) and which simulates the processes which lead to the formation of the flux of the machine taking into account the machine parameters, with an input for the parameter ($R_M{}^L$) of the rotor impedance of the machine and an output for an output signal which corresponds to the amount of the simulated flux or for output signals which correspond to the vector components ($\Psi_{M\alpha}$, $\Psi_{M\beta}$) of the simulated flux,

c) a calculation stage (36) which determines a scalar quantity (e) which determines the machine EMK-vector and a corresponding scalar quantity ($e_M$) which determines a second vector (components $e_{M\alpha}$, $e_{M\beta}$) which is assigned to the simulated flux (components $\Psi_{M\alpha}$, $\Psi_{M\beta}$), and

d) a regulator (11) whose input is supplied with the difference (subtraction stage 10) of the defining quantity determined in the calculation stage and whose output is connected to the input of the calculation model circuit (6) (Fig. 6).

11. A device as claimed in Claim 10, characterised in that the machine EMK-vector is established in the EMK-detector (30) and the model flux vector is established in the calculation model circuit (6) by determining their components in a predetermined reference system, that either the calculation stage (36) contains differentiators (34, 35) for the component-wise differentiation of the model flux vector or the EMK-detector contains integrators for the component-wise integration of the machine EMK-vector, and that the calculation stage (36) further contains a device (37, 38) which determines the difference of the vector amounts from the components of the machine EMK-vector and the differentiated model flux vector or the integrated machine EMK-vector and the model flux vector (Fig. 6).

12. A device as claimed in Claim 10, characterised in that the machine EMK-vector is established in the EMK-detector (30) and the model flux vector is established in the calculation model circuit (6) component-wise in relation to a predetermined coordinate system, that either the calculation stage (36) contains differentiators (34, 35) for the component-wise differentiation of the model flux vector, or the EMK-detector contains integrators for the component-wise integration of the machine EMK-vector, and that the calculation stage (36) additionally contains a vector analyser (50) which is supplied with the stator currents and which serves to form current angle values (sin $\kappa$, cos $\kappa$) which describes the position of the stator current vector in this coordinate system, together with a device (51, 52) which is supplied with the current angle values and forms the components ($e_{j2}$, $e_{Mj2}$) perpendicular to the stator current vector of the machine EMK-vector and of the differentiated model flux vector by transformation of the coordinates, and the components of the integrated machine EMK-vector and of the model flux vector parallel to the stator current vector, which it supplies to the input of the regulator 11 in order to form the difference of the scalar determinance (Fig. 7).

13. A device as claimed in Claim 12, characterised in that in place of the EMK-vector the EMK-detector (60) forms the sum vector (components $s_\alpha$, $s_\beta$) of machine EMK-vector and ohmic voltage drop, in that from the components ($U_\alpha$, $U_\beta$) of the voltage vector there is deducted only the product of a value corresponding to the stray inductance ($L^\sigma$) of the machine and the time-derivation (differentiators 31, 32) of the stator current components ($i_\alpha$, $i_\beta$) (Fig. 8).

14. A device as claimed in Claim 12 or 13, characterised in that the difference of the components of the two vectors is formed in that the components of the first vector are each fed to an amplifier (63) to which the corresponding component of the other vector is subtractively connected, and that the outputs of the amplifiers (63) are fed to the coordinate transformation device (64).

15. A device as claimed in the combination of Claims 13 and 14, characterised in that in the coordinate transformation device (64) the other component of the input vector is determined and is fed to the dividend input of a divider (65), that the vector analyser (50) which is supplied with the stator current also determines the amount of the stator current which it feeds to the divisor input of the divider (65) and that the value for the stator resistance ($R^S$) of the machine is tapped from the output of the divider (65).

## Revendications

1. Procédé pour déterminer la résistance ($R^L$) du rotor d'une machine asynchrone, caractérisé par le fait qu'on détermine un premier vecteur associé à la force électromotrice de la machine en calculant le vecteur de la f.e.m. ($e_\alpha$, $e_\beta$) ou le vecteur du flux ($\Psi_\alpha$, $\Psi_\beta$) à partir des tensions du stator ($U_R$, $U_S$) et des courants statoriques ($i_R$, $i_S$),

— qu'on forme un vecteur du flux ($\Psi_{M\alpha}$, $\Psi_{M\beta}$) associé à un modèle de calcul (6), auquel cas le modèle de calcul est obtenu à partir des courants du stator, de la position du rotor (sin λ, cos λ) de la machine et d'un paramètre réglable de modèle ($R_M{}^L$) pour la résistance ($R^L$) du rotor et simule la dynamique des processus aboutissant à l'apparition du flux magnétique de la machine,

— on forme la différence de deux grandeurs, dont l'une est une grandeur caractéristique du premier vecteur associé à la machine (« grandeur caractéristique de la machine »), et la seconde grandeur (« grandeur caractéristique du modèle ») est une grandeur caractéristique correspondante d'un second vecteur pouvant être dérivé du vecteur du flux simulé, et

— on modifie le réglage du paramètre du modèle ($R_M{}^L$) jusqu'à ce que la différence soit minimale, auquel cas le paramètre du modèle ($R_M{}^L$) réglé pour la différence minimale est rendu égal à la résistance ($R^L$) devant être calculée, du rotor de la machine (figures 6 ou 2).

2. Procédé suivant la revendication 1, caractérisé par le fait qu'on utilise comme grandeur caractéristique de la machine la valeur ($\Psi$) du vecteur ($\Psi_\alpha$, $\Psi_\beta$) du flux de la machine, formé par intégration du vecteur de la f.e.m. de la machine et qu'on utilise comme grandeur caractéristique du modèle la valeur ($\Psi_M$) du flux simulé (figure 2).

3. Procédé suivant la revendication 1, caractérisé par le fait qu'on utilise comme grandeur caractéristique les valeurs (e, $e_M$) du vecteur ($e_\alpha$, $e_\beta$) de la f.e.m. de la machine et un vecteur ($e_{M\alpha}$, $e_{M\beta}$) de la f.e.m. du modèle calculé à partir du vecteur du flux ($\Psi_{M\alpha}$, $\Psi_{M\beta}$) simulé et servant de second vecteur (figure 6).

4. Procédé suivant la revendication 3, caractérisé par le fait que la valeur ($e_M$) du vecteur ($e_{M\alpha}$, $e_{M\beta}$) de la f.e.m. du modèle est déterminée par différentiation (différentiateurs 34, 35) du vecteur du flux ($\Psi_{M\alpha}$, $\Psi_{M\beta}$) calculé à partir du flux simulé, et par formation ultérieure de la valeur (d'analyseur vectoriel 38) (figure 6).

5. Procédé suivant l'une des revendications 2 à 4, caractérisé par le fait que le vecteur ($e_\alpha$, $e_\beta$) de la f.e.m. de la machine est déterminé à partir du vecteur de la tension du stator ($U_\alpha$, $U_\beta$) après soustraction de la chute ohmique de tension et de la tension de dispersion inductive (figure 6).

6. Procédé suivant la revendication 1, caractérisé par le fait qu'on utilise comme grandeurs caractéristiques les composantes réactives ($e_{j2}$, $e_{Mj2}$) du vecteur ($e_\alpha$, $e_\beta$) de la f.e.m. de la machine servant de premier vecteur, et d'un vecteur ($e_{M\alpha}$, $e_{M\beta}$) (figure 7), de la f.e.m. du modèle, calculé à partir du vecteur de flux simulé, ou la composante active du vecteur du flux de la machine servant de premier vecteur et un vecteur du flux de modèle calculé à partir du flux simulé et servant de second vecteur.

7. Procédé suivant la revendication 6, caractérisé par le fait que la composante réactive du vecteur de la f.e.m. de la machine est déterminée par formation de la composante réactive du vecteur somme (composantes $s_\alpha$, $s_\beta$) (figure 8) à partir du vecteur f.e.m. de la machine et de la chute ohmique de tension, ou la composante active du vecteur du flux de la machine à partir de l'intégrale de la composante réactive du vecteur somme, ce vecteur somme étant formé par la différence de la tension du stator et de la tension de dispersion inductive (figure 8).

8. Procédé suivant la revendication 7, caractérisé par le fait que l'on forme, comme différence supplémentaire, également la différence des autres composantes des premier et second vecteurs, que l'on divise cette différence supplémentaire par la valeur du courant statorique et qu'on prélève la valeur obtenue pour la valeur minimale de cette différence supplémentaire, en tant que valeur de la résistance ($R^S$) du stator (figure 8).

9. Procédé suivant l'une des revendications 6 à 8, caractérisé par le fait qu'on forme la différence des composantes réactives ou des composantes actives des vecteurs par formation des composantes réactives ou des composantes actives des différences des vecteurs (figure 8).

10. Dispositif pour la mise en œuvre du procédé suivant l'une des revendications 1 à 9, caractérisé par :

a) un détecteur (30) de la f.e.m., chargé par les courants de phase ($i_\alpha$, $i_\beta$) et par les tensions de phase ($U_\alpha$, $U_\beta$) pour la formation d'un premier vecteur associé à la f.e.m. de la machine (composantes $e_\alpha$, $e_\beta$),

b) un circuit de modèle de calcul (6) qui est chargé par les courants de phase ($i_\alpha$, $i_\beta$) et par un signal de position du rotor (sin λ, cos λ) et qui simule les phénomènes conduisant à la formation du flux de la machine en tenant compte des paramètres de la machine, avec une entrée d'introduction pour le paramètre ($R_M^L$) de la résistance du rotor de la machine et une sortie pour un signal de sortie correspondant à la valeur du flux simulé ou pour des signaux de sortie correspondant aux composantes ($\Psi_{M\alpha}$, $\Psi_{M\beta}$) du vecteur du flux simulé,

c) un étage de calcul (36) qui détermine une grandeur scalaire (e), déterminant le vecteur de la f.e.m. de la machine, et une grandeur scalaire correspondante ($e_M$) déterminant un second vecteur (composantes $e_{M\alpha}$, $e_{M\beta}$) associé au flux simulé (composantes $\Psi_{M\alpha}$, $\Psi_{M\beta}$) et

d) un régulateur (11) à l'entrée duquel est envoyée la différence (point de soustraction 10) des grandeurs caractéristiques déterminées dans l'étage de calcul et dont la sortie est reliée à l'entrée d'introduction du circuit de modèle de calcul (6) (figure 6).

11. Dispositif suivant la revendication 10, caractérisé par le fait que le vecteur de la f.e.m. de la machine dans le détecteur de la f.e.m. (30) et le vecteur du flux du modèle dans le circuit de modèle de calcul (6) peuvent être calculés par détermination de leurs composantes dans un système de référence prédéterminé, que soit l'étage de calcul (36) contient des différentiateurs (34, 35) pour différentier composantes pour composantes le vecteur du flux du modèle, soit le détecteur de la f.e.m. contient des intégrateurs pour réaliser l'intégration, composante pour composante, du vecteur de la f.e.m. de la machine, et que l'étage de calcul (36) contient en outre un dispositif (37, 38) qui détermine la différence des valeurs des vecteurs à partir des composantes du vecteur de la f.e.m. de la machine et du vecteur différencié du flux du modèle ou du vecteur intégré de la f.e.m. de la machine et du vecteur du flux du modèle (figure 6).

12. Dispositif suivant la revendication 10, caractérisé par le fait que le vecteur de la f.e.m. de la machine peut être déterminé dans le détecteur de la f.e.m. (30) et que le vecteur du flux du modèle peut être déterminé dans le circuit de modèle de calcul (6), composante pour composante, par rapport à un système de coordonnées prédéterminé, que soit l'étage de calcul (36) contient des circuits différentiateurs (34, 35) servant à réaliser la différentiation, composante pour composante, du vecteur du flux du modèle, soit que le détecteur de la f.e.m. contient des intégrateurs servant à réaliser l'intégration, composante pour composante, du vecteur de la f.e.m. de la machine, et que l'étage de calcul (36) contient en outre un analyseur vectoriel (50), qui est chargé par les courants statoriques et sert à former des grandeurs angulaires du courant (sin κ, cos κ) décrivant la position du vecteur du courant statorique dans ce système de coordonnées, ainsi qu'un dispositif (51, 52) qui est chargé par les grandeurs angulaires du courant et qui, par transformation des coordonnées, forme les composantes ($e_{j2}$, $e_{Mj2}$), perpendiculaires au vecteur du courant statorique, du vecteur de la f.e.m. de la machine et du vecteur du flux du modèle différentié ou les composantes, parallèles au vecteur du courant statorique, du vecteur intégré de la f.e.m. de la machine et du flux du vecteur du modèle, et envoie ces composantes à l'entrée du régulateur (11) en vue de la formation de la différence des grandeurs caractéristiques scalaires (figure 7).

13. Dispositif suivant la revendication 12, caractérisé par le fait que le détecteur de la f.e.m. (60) forme, à la place du vecteur de la f.e.m., le vecteur somme (composantes $s_\alpha$, $s_\beta$) à partir du vecteur de la f.e.m. de la machine et de la chute ohmique de tension, par le fait que seul le produit d'une grandeur correspondant à l'inductance de dispersion ($L^\sigma$) de la machine, par la dérivée dans le temps (circuits différentiateurs 31, 32) des composantes ($i_\alpha$, $i_\beta$) du courant statorique est soustrait des composantes ($U_\alpha$, $U_\beta$) du vecteur de la tension (figure 8).

14. Dispositif suivant la revendication 12 ou 13, caractérisé par le fait qu'on forme la différence des composantes des deux vecteurs en envoyant les composantes d'un vecteur à un amplificateur (63) auquel est appliquée de façon soustractive la composante correspondante de l'autre vecteur, et que les signaux de sortie des amplificateurs (63) sont envoyés au dispositif (64) servant à réaliser la transformation des coordonnées.

15. Dispositif suivant la combinaison des revendications 13 et 14, caractérisé par le fait que les autres composantes du vecteur introduit sont également déterminées dans le dispositif (64) servant à réaliser la transformation des coordonnées et sont envoyées à l'entrée du dividende d'un diviseur (65), que l'analyseur vectoriel (5) chargé par le courant statorique détermine également la valeur de ce courant statorique et l'envoie à l'entrée de division du diviseur (65) et que la valeur de la résistance ($R^S$) du stator de la machine est prélevée sur la sortie du diviseur (65).

FIG 1

FIG 2

FIG 3

FIG 4

**0 047 900**

FIG 5

FIG 6

FIG 7

FIG 8